Europäisches Patentamt

European Patent Office

Office européen des brevets

(19)

(11) Publication number: 0 203 578
A2

(12) EUROPEAN PATENT APPLICATION

(21) Application number: 86107206.4

(22) Date of filing: 27.05.86

(51) Int. Cl.⁴: H 01 L 21/314, H 01 L 21/20, H 01 L 21/82

(30) Priority: 30.05.85 JP 115305/85

(43) Date of publication of application: 03.12.86
Bulletin 86/49

(84) Designated Contracting States: DE FR GB

(71) Applicant: HITACHI, LTD., 6, Kanda Surugadai 4-chome
Chiyoda-ku, Tokyo 100 (JP)

(72) Inventor: Takagi, Kazumasa, 2196-376, Hirai
Hinodemachi, Nishitama-gun Tokyo (JP)
Inventor: Susa, Kenzo, 2196-81, Hirai Hinodemachi,
Nishitama-gun Tokyo (JP)
Inventor: Kobayashi, Toshio, 2196-384, Hirai
Hinodemachi, Nishitama-gun Tokyo (JP)
Inventor: Takayama, Takanobu Hitachi
Dai 2 Kyoshin-ryo, 3-1-3-, Higashi-koigakubo,
Kokubunji-shi Tokyo (JP)

(74) Representative: Strehl, Schübel-Hopf, Groening, Schulz,
Widenmayerstrasse 17 Postfach 22 03 45,
D-8000 München 22 (DE)

(54) Semiconductor device having epitaxial insulating film and method of producing the same.

(57) In a semiconductor device, a metal oxide single crystal film (13, 15) having at least one-layered C-rare earth crystalline structure is formed by epitaxial growth on a semiconductor single crystal substrate (11) having a diamond structure or a cubic zincblende (ZnS) structure as its crystalline structure. Since the difference in thermal expansion coefficient is small between the semiconductor and the oxide, the thermal strain that develops in the semiconductor device can be reduced.

SEMICONDUCTOR DEVICE HAVING EPITAXIAL INSULATING

FILM AND METHOD OF PRODUCING THE SAME

BACKGROUND OF THE INVENTION

This invention relates to a semiconductor device having an epitaxial insulating film and a method of producing the same. More particularly, the present invention relates to a semiconductor device equipped with an epitaxial insulating film formed on a semiconductor substrate having a diamond structure or a cubic zincblende (ZnS) structure and a method of producing such a semiconductor device.

Amorphous films such as $SiO_2$, $Si_3N_4$, and the like have been widely employed at present as an insulating film for a variety of semiconductor devices such as MOS type semiconductor devices. With miniaturization of a gate width, however, the condition of an oxide-semiconductor interface has come to exert significant influences upon the device characteristics and an insulating film having semiconductor-lattice continuity has become more necessary than the amorphous film. On the other hand, compound semiconductors represented by gallium arsenide (GaAs) involve the problem that a thermal oxidized film can not be used as the insulating film.

As means for solving these problems, a semiconductor device having an epitaxial insulating film which has lattice matching with a semiconductor material has been proposed. Examples of the methods which enables epitaxial growth of a single crystal film of an insulating material are described in the following literature.

"MBE - grown fluoride films: A new class of epitaxial dielectrics", Farrow et al., J. Vac. Sci. Technol., $\underline{19}$(3), Sept/Oct. (1981), p. 415 - 420

"Epitaxial Growth of fluoride films on silicon substrates" Ishiwara et al., Mat. Res. Soc. Symp. Proc. Vol. 25 (1984), p. 393 - 403

They use group II fluorides represented by fluorite ($CaF_2$) as the insulating film. The former causes epitaxial growth of the fluoride film on Si, InP, CdTe, (Hg, Cd)Te or the like by molecular beam epitaxy (MBE) while the latter causes epitaxial growth of the fluoride film on Si by ordinary vacuum evaporation. The fluoride has a crystalline structure approximate to that of the semiconductor and, moreover, the lattice constant of the fluoride is approximate to that of the semiconductor. Therefore, matching of lattice constants can be attained by preparing a mixed crystal therefrom. For these reasons, these prior art methods form the epitaxial film of the group II fluoride on the semiconductor.

The group II fluoride has a high electrical resistance and is suitable for an insulating material. However, its thermal expansion coefficient is about $19 \times 10^{-6}$/K and is by far greater than that of Si and GaP (about $3 \times 10^{-6}$/K), InP and GaAs (about $5 \times 10^{-6}$/K), and Ge, ZnS and ZnSe (about $6 \sim 7 \times 10^{-6}$/K). Therefore, strain is likely to develop in the grown film during the drop of temperature from the growth temperature of above 400°C to room temperature.

On the other hand, mismatch of the lattice constants between the substrate and the insulator formed on the substrate is +5.48% in the case of $BaF_2$ and InP, -4.46% in the case of $BaF_2$ and CdTe, -1.2% in the case of $SrF_2$ and InP and +0.61% in the case of $CaF_2$ and Si. It is 0 in the case of a mixed crystal $(CaF_2)_{0.58}(CdF_2)_{0.42}$ and Si and in the case of $(SrF_2)_{0.8}(BaF_2)_{0.2}$ and InP, and hence an epitaxial film can be grown. As described above, mismatch of the lattice constants can be reduced by selecting a suitable mixed crystal between the group II fluorides but not a great difference in the thermal expansion coefficient therebetween.

## SUMMARY OF THE INVENTION

An object of the present invention is to provide a semiconductor device having an insulating single crystal film which can attain epitaxial growth on a semiconductor single crystal substrate having a diamond structure or a cubic zincblende structure as its crystalline structure and a method of producing such a semiconductor device.

It is another object of the present invention to provide a semiconductor device having an epitaxial insulating film which has an oxide single crystal film having at least one-layered C-rare earth structure formed on a semiconductor single crystal substrate having a diamond or a cubic zincblende structure by epitaxial growth.

## BRIEF DESCRIPTION OF THE DRAWINGS

Fig. 1 is a schematic view of a vacuum evaporator used in forming an insulating film in accordance with the present invention;

Fig. 2 is a process diagram of the present invention;

Figs. 3, 4 and 5 are sectional views of a semiconductor device in accordance with one embodiment of the present invention; and

Fig. 6 is a sectional view of the crystalline structure of C-rare earth.

DESCRIPTION OF THE PREFERRED EMBODIMENTS

The present invention is based upon the finding that an oxide represented by the molecular formula $Ln_2O_3$ [where Ln is at least one element selected from the group consisting of yttrium (Y), scandium (Sc) and rare earth metal elements] is suitable as an insulating material which can be grown epitaxially on a semiconductor substrate having a diamond crystal structure (e.g. Si, Ge) or a cubic zincblende structure (e.g. GaP, GaAs, InP, InAs) as its crystalline structure.

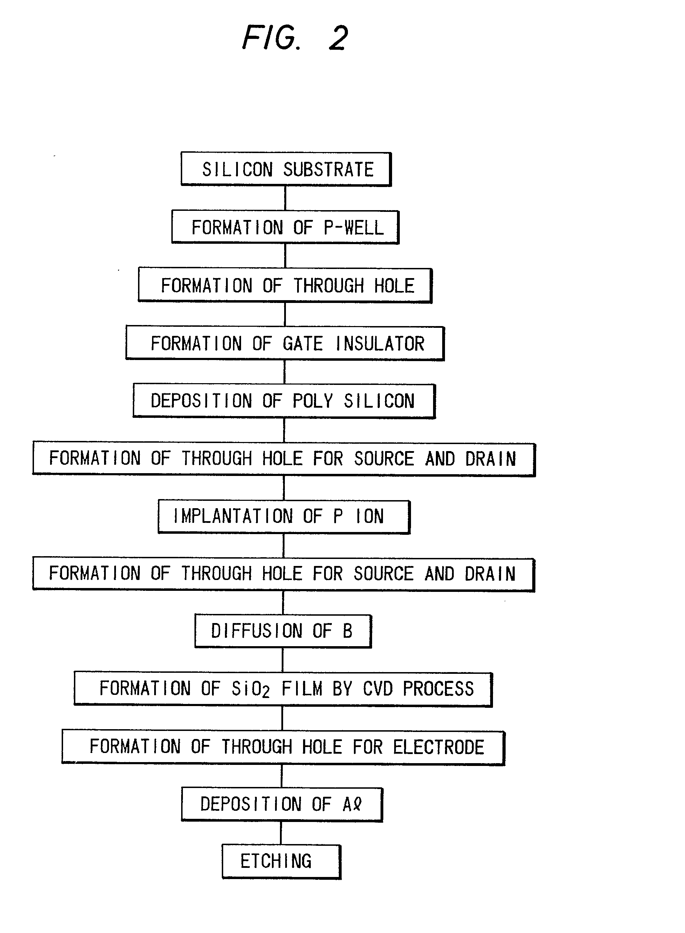

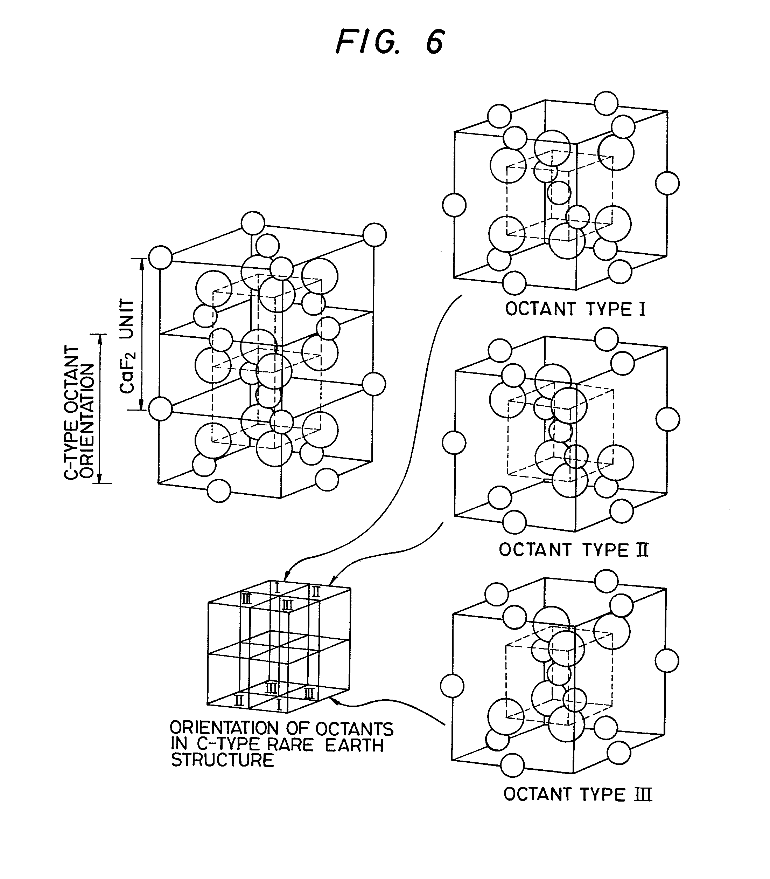

The rare earth sesqui oxide has a C-rare earth structure as its crystalline structure. Though varying with the kind of the rare earth metal elements, the lattice constants are substantially in the range of from 98.45 to 114.0 nm. On the other hand, the lattice constants of the semiconductors having the diamond structure or the zincblende structure are substantially in the range of from 54.307 to 60.584 nm and are a half of the lattice constant of the rare earth sesqui oxide. The C-rare earth structure is classified into the same crystalline structure group as the diamond structure, the zincblende (ZnS) and fluorite ($CaF_2$). The atomic orientation is such that an octant is obtained by substituting the fluorine atoms of the unit cell of the $CaF_2$ structure by the oxygen atoms and then removing two oxygen atoms at the symmetric positions, and two such octants are stacked transversely, longitudinally and vertically. Since the defects of the oxygen atoms are threefold, periodicity occurs only after two octants approximate to $CaF_2$ are stacked to form the unit cell. This crystalline structure is shown in Fig. 6. In connection with the orientation of the rare earth metal atoms, however, it is the same orientation as the metal atoms in $CaF_2$, that is, diamond and ZnS, and the period is 1/2 of the lattice constant of the C-rare earth structure. Therefore, it is found that if the difference in the lattice constant is small between twice the lattice constant of the diamond or cubic structure and the lattice constant of the C-rare earth structure, the rare earth sesquioxide can be grown epitaxially on the substrate. The thermal expansion coefficient of the rare earth sesquioxide is about $10 \times 10^{-6} \cdot K^{-1}$ and is a little smaller than twice the thermal expansion coefficient of the semiconductor, i.e. $4 \sim 5 \times 10^{-6} \cdot K^{-1}$. Therefore, the

thermal strain occurring in the epitaxial film and the semiconductor substrate can be much more reduced when compared with the group II fluorides.

The epitaxial insulating film of the present invention can be formed by epitaxially growing an oxide film of the C-rare earth crystalline structure on a semiconductor single crystal substrate disposed in a vacuum evaporation chamber while evaporating a rare earth metal element by resistance heating, electron beam heating or the like inside the vacuum evaporator and introducing an oxygen gas or oxidizing gas containing oxygen such as $H_2O$ which has a predetermined partial pressure.

Now, the present invention will be described in detail with reference to preferred embodiments thereof.

Embodiment 1

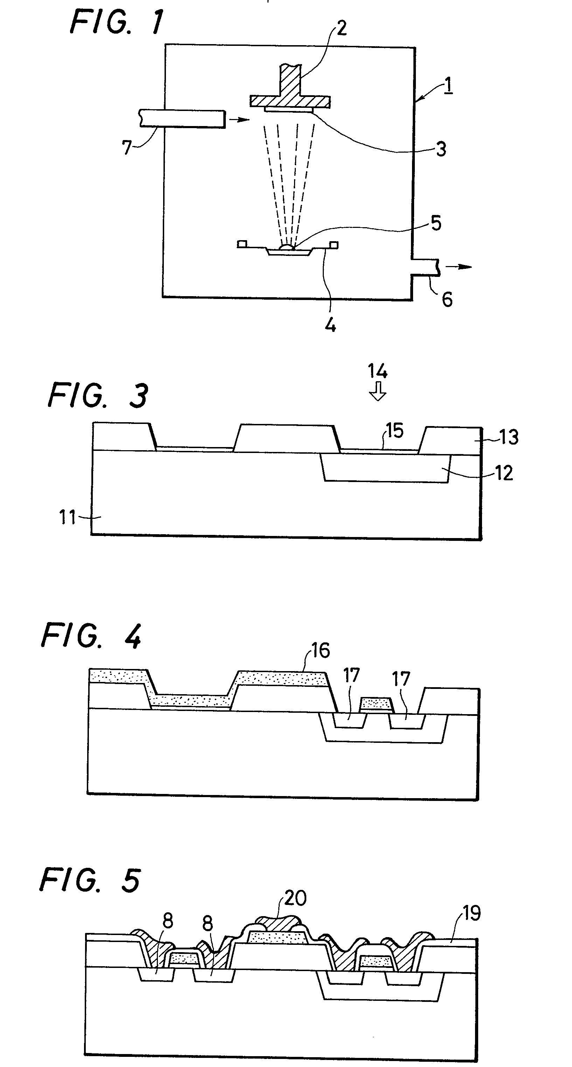

Fig. 1 is a schematic view of a vacuum evaporation equipment used in producing the insulating film of the present invention.

After a Si (100) single crystal substrate 3 (diameter: 50 mm) was subjected to a surface cleaning process, the substrate 3 was fitted to a substrate support 2 equipped with a heater inside the vacuum evaporation chamber 1, and the inside of the chamber was evacuated to 2.7 µPa through an evacuating pipe 6. The substrate 3 was then heated to 400°C. While evacuation was being continued, oxygen was introduced into the chamber 1 through an oxygen inlet pipe 7 so that the oxygen partial pressure attained 6.7 mPa inside the chamber 1. In this state a tantalum (Ta) boat heater 4 storing therein metallic europium (Eu) 5 was heated by resistance heating to evaporate the metal into a film thickness of 20 nm at a deposition rate of 0.05 nm/s. When evaluated by an RHEED (reflected high energy electron diffraction) method, the film was found to be $Eu_2O_3$ and to have the plane orientation of (100) in the same way as the Si substrate 3. Furthermore, the film was found to have grown epitaxially. When the section of this film was examined with a high resolution transmission electron microscope, it was confirmed that continuity of a lattice image existed between Si of the substrate and $Eu_2O_3$ of the film. An Aℓ electrode was formed on the $Eu_2O_3$ insulating film and the breakdown field strength of the insulating film was examined. It was found that the breakdown field strength was $7 \times 10^6$ V/cm, did not have any dependency upon the electrode area and was devoid of defects such as pin-holes.

Embodiment 2

A Si (100) single crystal substrate 3 was placed in a vacuum evaporation chamber 1 and the inside of the chamber 1 was evacuated to 1.3 μPa in the same way as in Embodiment 1. The substrate 3 was then heated to 250°C. While the vacuum as specified above was being kept, Eu was vacuum-evaporated in a thickness of 0.2 nm. Thereafter, oxygen was introduced into the chamber so that the partial oxygen pressure attained 13 mPa inside the chamber. In this state Eu was further vacuum-evaporated to a thickness of 10 nm at a deposition rate of 0.1 nm/s. When the resulting film was evaluated by the RHEED method and the high resolution transmission electron microscope in the same way as in Embodiment 1, the epitaxial growth of the film on the Si substrate as well as the continuity on the interface between the film and the substrate were confirmed. Furthermore, the epitaxial growth of $Eu_2O_3$ was also confirmed when $H_2O$ was introduced to $5 \times 10^{-4}$ Torr in place of oxygen. The breakdown field strength was found to be $6.8 \times 10^6$ V/cm.

Embodiment 3

Lanthanum (La) and neodymium (Nd) simultaneously vacuum-evaporated on a GaAs (100) single crystal substrate in a oxygen-containing atomsphere in the same way as in Embodiment 2.  That is, the vacuum attained was 2.7 μPa,    the substrate temperature was 250°C and the oxygen partial pressure was 13 mPa.   The deposition rates of La and Nd were 0.07 nm/s, respectively.  The resulting film was a mixed crystal oxide of $(La \cdot Nd)_2O_3$, its lattice constant was 1.130 nm and was grown epitaxially on the GaAs single crystal substrate.

Embodiment 4

A Si film was formed further on the $Eu_2O_3$ epitaxial insulating film formed by the method of Embodiment 1.  Namely, after Eu was vacuum-evaporated in an atmosphere having an oxygen partial pressure of 6.7 mPa,    the introduction of oxygen was stopped and the inside of the vacuum evaporation chamber was evacuated to 2.7 μPa.    In this state the substrate was heated to 700°C and, at the same time, Si was vacuum-evaporated in a film thickness of 100 nm by electron beam heating at a deposition rate of 0.2 nm/s.

The resulting Si film had grown epitaxially on the $Eu_2O_3$ film and had the same (100) plane orientation as the Si single crystal used as the substrate.

Embodiment 5

Yttrium (Y) was vacuum-evaporated on a Si (100) single crystal substrate in an oxygen-containing atmosphere in the same was as in Embodiment 1. Namely, the vacuum attained was 1.3 μPa, the substrate temperature was 300°C and the oxygen partial pressure was 13 mPa. Yttrium (Y) was vacuum-evaporated by electron beam heating and the deposition rate was 0.1 nm/s. It was confirmed by the RHEED method that in the case of Y, too, the $Y_2O_3$ film having the C-rare earth crystalline structure had grown epitaxially on the Si substrate in the same way as in the case of Eu. The breakdown field strength of the $Y_2O_3$ film was 5.0 x $10^6$ V/cm.

Embodiment 6

Terbium (Tb) was vacuum-evaporated on the Si (100) single crystal substrate in the same way as in Embodiment 5. The oxygen partial pressure, the vacuum attained and the substrate temperature were the same as in Embodiment 5. Vacuum-evaporation of Tb was effected by electron beam heating, and the deposition rate was 0.05 nm/s. The film formed on the Si substrate consisted of $Tb_2O_3$ having the C-rare earth structure and had the same orientation relationship as the substarte. The breakdown field strength of this film was 6.2 x $10^6$ V/cm.

Embodiment 7

A gadolinium (Gd) oxide film was formed on the Si (100) single crystal substrate by sputtering. A targed used was produced by spreading square pellets of Gd (10 mm square) on a quartz glass disc (diameter: 150 mm). After a sputtering apparatus was evacuated to 6.7 μPa, Ar+5%$O_2$ gas was introduced and the pressure inside the apparatus was adjusted to 67 mbar by adjusting a main valve for regulating the gas flow rate. The input high frequency power was 200 W, the substrate temperature was 200°C at the time of sputtering and the distance between the substrate and the target was 70 mm. The deposition rate of the film was 0.12 nm/s. When a 0.1 μm-thick film was formed, it was confirmed that a $Gd_2O_3$ film had grown epitaxially. The breakdown field strength of this film was 4.9 x $10^6$ V/cm.

The foregoing embodiments illustrate $Eu_2O_3$, $(La, Nd)_2O_3$, $Tb_2O_3$ and $Gd_2O_3$ as the rare earth metal oxides, but substantially the same result can be obtained when other rare earth oxides and their mixed crystals are used from the viewpoint of similarity of chemical and physical properties of rare earth metal elements. This also holds true of Sc oxides.

Additionally, the substrate heating temperature is preferably up to about 800°C.

Now a practical example of the production of a semiconductor device will be given.

The basic structure of C-MOS was formed by use of a neodymium epitaxial insulating film. The production process was as shown in Fig. 2 and the structures after the primary process steps were as shown in Figs. 3 to 5. A P-well 12 was first formed on an N-type Si substrate 11, and a $Nd_2O_3$ film was grown epitaxially on the P-well by reactive evaporation to obtain a field oxide film 13. After a through hole 14 was formed in the field oxide film 13 by ordinary photo-lithography and etching, the $Nd_2O_3$ film was again formed to obtain a gate insulating film 15 (see Fig. 3).

Next, a polysilicon layer 16 was formed and through holes for source and drain were bored by photo-lithography and etching to remove the polysilicon. Then, the gate insulating film 15 was etched selectively by using the remaining polysilicon layer as the mask. An N-type source-drain was formed by doping phosphorus (P) by ion implantation.

The same lithography and etching steps were repeated to form a P-type source-drain region 18. A $SiO_2$ film 19 was formed by chemical vapor deposition (CVD) and, after an electrode hole was bored, an Aℓ electrode 20 was vacuum-evaporated, followed by etching.

When the characteristics of the resulting C-MOS were evaluated, the C-MOS exhibited the same characteristics as the $SiO_2$ gate MOS, although the production process was merely an experimental process. In consideration of the properties of the rare earth oxide as the insulating film, too, it may be believed that the device characteristics can be further improved. Since this epitaxial insulating film has a high dielectric constant, it can be used presumably as a capacitor. Furthermore, if a silicide is used for the electrode material, the devices can of course be stacked three-dimensionally by the epitaxial growth.

As can be understood clearly from the description given above, the present invention discloses that a metal oxide represented by the molecular formula $Ln_2O_3$ (where Ln is at least one element selected from the group consisting of Y, Sc and rare earth metal elements) can be used as a metal oxide insulating film material which can be grown epitaxially on a semiconductor substrate having a diamond structure or a cubic zincblende structure as its crystalline structure. In addition, this metal oxide film has less defect such as pin-holes and exhibits a high breakdown field strength as the insulating film.  Since the difference in thermal expansion coefficient between the substrate and the insulating film is smaller than that between the substrate and group II fluorides, thermal strain is less likely to occur in the production process of the semiconductor device using this insulating film. Furthermore, since mismatch of lattice constants between the semiconductor substrate and the insulating film can be reduced, semiconductor devices having a multi-layered film structure can be produced.

CLAIMS:

1. A semiconductor device having an epitaxial insulating film, which comprises an oxide single crystal film (13, 15) having at least one-layered C-rare earth crystalline structure formed by epitaxial growth on a semiconductor single crystal substrate (1) having a diamond structure or a cubic zincblende structure as its crystalline structure.

2. A semiconductor device having an epitaxial insulating film according to claim 1, wherein said oxide having the C-rare earth structure is a oxide represented by the molecular formula $Ln_2O_3$ (where Ln is at least one metal element selected from the group consisting of yttrium, scandium and rare earth metal elements).

3. A method of producing a semiconductor device having an epitaxial insulating film, which comprises the steps of supplying vapor of an Ln metal (where Ln represents yttrium, scandium or rare earth metal elements) and oxygen gas or an oxygen-containing oxidizing compound gas onto a semiconductor single crystal substrate having a diamond structure or a cubic zincblende structure as its crystalline structure, and effecting epitaxial growth of a metal oxide film represented by the molecular formula

$Ln_2O_3$ and having a C-rare earth crystalline structure on said semiconductor substrate.

FIG. 1

FIG. 3

FIG. 4

FIG. 5

2/3

# FIG. 2

```
          ┌─────────────────────────┐
          │    SILICON SUBSTRATE     │
          └─────────────────────────┘
                      │
          ┌─────────────────────────┐
          │   FORMATION OF P-WELL    │
          └─────────────────────────┘
                      │
          ┌─────────────────────────────┐
          │  FORMATION OF THROUGH HOLE   │
          └─────────────────────────────┘
                      │
          ┌─────────────────────────────┐
          │ FORMATION OF GATE INSULATOR  │
          └─────────────────────────────┘
                      │
          ┌─────────────────────────────┐
          │  DEPOSITION OF POLY SILICON  │
          └─────────────────────────────┘
                      │
     ┌──────────────────────────────────────────────┐
     │ FORMATION OF THROUGH HOLE FOR SOURCE AND DRAIN │
     └──────────────────────────────────────────────┘
                      │
          ┌─────────────────────────────┐
          │    IMPLANTATION OF P ION     │
          └─────────────────────────────┘
                      │
     ┌──────────────────────────────────────────────┐
     │ FORMATION OF THROUGH HOLE FOR SOURCE AND DRAIN │
     └──────────────────────────────────────────────┘
                      │
          ┌─────────────────────────┐
          │     DIFFUSION OF B       │
          └─────────────────────────┘
                      │
     ┌──────────────────────────────────────────┐
     │ FORMATION OF SiO2 FILM BY CVD PROCESS     │
     └──────────────────────────────────────────┘
                      │
     ┌──────────────────────────────────────────┐
     │ FORMATION OF THROUGH HOLE FOR ELECTRODE    │
     └──────────────────────────────────────────┘
                      │
          ┌─────────────────────────┐
          │    DEPOSITION OF Aℓ      │
          └─────────────────────────┘
                      │
          ┌─────────────────────────┐
          │        ETCHING          │
          └─────────────────────────┘
```

3/3

# FIG. 6

OCTANT TYPE I

OCTANT TYPE II

C-TYPE OCTANT ORIENTATION

CaF₂ UNIT

ORIENTATION OF OCTANTS
IN C-TYPE RARE EARTH
STRUCTURE

OCTANT TYPE III